# EUROPÄISCHE PATENTSCHRIFT

(11) **EP 1 158 523 B1**
(45) Veröffentlichungstag und Bekanntmachung des Hinweises auf die Patenterteilung: **27.02.2008**
(21) Anmeldenummer: 01110246.4
(22) Anmeldetag: 25.04.2001
(51) Int. Cl.: G11C 5/14, G05F 1/46

(54) **Adressgenerator zur Erzeugung von Adressen für eine On-Chip Trimmschaltung**
Address generator for generating addresses for an on chip trimming circuit
Générateur d'adresses pour générer des adresses pour un circuit d'ajustement sur puce

(30) Priorität: 10.05.2000 DE 10022767
(43) Veröffentlichungstag der Anmeldung: 28.11.2001
(73) Patentinhaber: Infineon Technologies AG, 81669 München (DE)
(72) Erfinder: Krause, Gunnar, 81541 München (DE); Spirkl, Wolfgang, Dr., 82110 Germering (DE)
(74) Vertreter: Müller - Hoffmann & Partner

(56) Entgegenhaltungen:
- US-A- 3 906 195
- US-A- 3 978 413
- US-A- 5 404 049
- US-A- 5 982 163

## Beschreibung

Die Erfindung betrifft einen Adressgenerator zur Erzeugung von Adressen für eine On-Chip Trimmschaltung zur Abstimmung von auf einem Halbleiterchip erzeugten Referenzspannungen, wobei der Adressgenerator elektrische Fuses aufweist.

Die am 14.12.1999 angemeldete DE 199 60 244.1 des vorliegenden Anmelders beschreibt eine Anordnung zum Trimmen von Referenzspannungen in Halbleiterchips.

Insbesondere bei integrierten Speicherbausteinen, z.B. DRAMs, müssen auf dem Chip befindliche Spannungsgeneratoren in ihrer aufgrund von Fertigungstoleranzen schwankenden Sollspannung abgeglichen oder getrimmt werden. Zur Kalibrierung schlägt die zuvor genannte Patentanmeldung einen Adressgenerator auf dem Chip vor, der mit einer Trimmschaltung verbunden ist und die möglichen Kalibrierungsstufen durchzählt. Mit einem derartigen Adressgenerator sind elektrische "Fuses" verbunden, um die durch den Adressgenerator für die Trimmschaltung erzeugten Adressen bei Übereinstimmung der jeweiligen veränderlichen Referenzspannung mit einer von außen zugeführten Vergleichsspannung dauerhaft zu speichern, indem jeweils eine elektrische Fuse entsprechend der endgültigen Adressinformation geschossen oder nicht geschossen wird.

Allgemein ist es bei hochintegrierten Halbleiterschaltungen, wie z.B. bei einem 256M SDRAM erforderlich, die von einer Funktionseinheit benötigte Fläche auf dem Halbleiterchip möglichst klein zu halten und die Anzahl der Steuerleitungen zu reduzieren.

US-A-5 982 163 offenbart einen Signalgenerator zur Erzeugung von Signalen für eine On-Chip-Trimmschaltung zur Abstimmung einer auf einem Halbleiterchip erzeugten Referenzspannung. Dieser bekannte Signalgenerator enthält eine Fusegruppe und eine Dekodierschaltung, die die in der Fusegruppe durch Schießen der Fuses eingegebene Information dekodiert und den dekodierten Wert einer Steuerschaltung für eine interne Versorgungsspannungsquelle zuführt. In dieser Druckschrift ist aber keine Adressgeneratorschaltung beschrieben, die dazu dient, die von ihm generierte Adresse bei Übereinstimmung einer veränderlichen Referenzspannung des Halbleiterchips mit einer von außen zugeführten Vergleichsspannung in den in dem Adressgenerator enthaltenenen elektrischen Fuses dauerhaft zu speichern. Bei der in dieser Druckschrift beschriebenen Trimmschaltung werden dagegen die Fuses auf irgendeine andere Weise geschossen bzw. durchtrennt.

US-A-3 906 195 beschreibt einen synchronen Zähler, der umschaltbar entweder als Vorwärts- oder als Rückwärtszähler oder auch als Schieberegister verwendbar ist und aus J-K Flipflops, d.h. aus Master-Slave-Flipflops besteht, die nicht transparent sind und deshalb keine Speicherlatches bilden.

Es ist deshalb Aufgabe der Erfindung, einen derartigen Adressgenerator so zu ermöglichen, dass die von ihm benötigte Fläche auf dem Halbleiterchip optimiert, die Anzahl der Steuerleitungen reduziert und außerdem ein möglichst flexibles, an unterschiedliche funktionelle Anforderungen anpassbares Schaltungsdesign erzielt wird.

Diese Aufgabe wird anspruchsgemäß gelöst.

Gemäß einem wesentlichen Aspekt weist ein erfindungsgemäßer Adressgenerator eine bestimmte Anzahl M von aus jeweils einem Speicherlatch bestehenden Stufen auf, die auf ein einem Steuereingang des Adressgenerators zugeführtes Steuersignal und auf ein einem Takteingang desselben angelegtes Taktsignal wahlweise als synchroner Zähler oder als Schieberegister betreibbar sind, wobei M gleich oder größer als 1 ist, und in den elektrischen Fuses ist eine vom Adressgenerator generierte Adresse für die Trimmschaltung bei Übereinstimmung einer veränderlichen Referenzspannung des Halbleiterchips mit einer von außen zugeführten Vergleichsspannung dauerhaft speicherbar.

Die Stufen des Adressgenerators weisen jeweils eine der zuvor erwähnten elektrischen Fuses auf. Jedes Speicherlatch weist MOS-Transistoren auf, um die den elektrischen Fuses zuzuführende Adressinformation an den CMOS-Pegel anzupassen.

Die Speicherlatches haben einen gemeinsamen Initialisierungseingang und einen Ladeeingang und sind derart eingerichtet, dass ein am Ladeeingang angelegtes Signal nur bei jeweils intakten (oder geschossenen) Fuses die Latchinformation in den zum Initialisierungswert komplementären Wert bringt.

In bevorzugter Weiterbildung kann der Adressgenerator um folgende weitere Funktionen ergänzt werden:
- Der Adressgenerator kann einen seriellen Eingang und einen seriellen Ausgang zum Auslesen des Zählerstands bzw. der Fuseinformation aufweisen;
- der Adressgenerator kann weiterhin Rückkopplungsglieder aufweisen, die den seriellen Ausgang wahlweise zum seriellen Eingang zurückkoppeln;
- Durch die Rückkopplung des seriellen Ausgangs auf den seriellen Eingang kann der Zählerstand bzw. die Fuseinformation nicht zerstörend am seriellen Ausgang ausgelesen werden. Andererseits kann andere, z.B. Testinformation an den seriellen Eingang angelegt und taktgesteuert in den Adressgenerator übernommen werden;
- es kann weiterhin ein Programmiereingang am Adressgenerator vorgesehen sein, um mit der in den Speicherlatches vorhandenen Information die Fuses bitweise zu programmieren;
- außerdem kann ein Vorwärts-Rückwärts-Wahleingang zur Wahl der Zählrichtung des Zählers bzw. der Schieberichtung des Schieberegisters des Adressgenerators vorgesehen sein;
- das Schieberegister des Adressgenerators kann um ein weiteres Speicherlatch (1 Bit) erweitert werden, in welches ein momentanes (JA/NEIN) Vergleichsergebnis eines Spannungskomparators speicherbar ist, der die momentane von der Trimmschaltung erzeugte Spannung mit einer externen Vergleichsspannung vergleicht. Das in dem zusätzlichen Speicherelement eingespeicherte Vergleichsergebnis kann dann zusammen mit dem generierten Adressenwert am seriellen Ausgang ausgegeben werden.

Vorteilhafterweise optimiert der erfindungsgemäße Adressgenerator die benötigte Fläche auf dem Halbleiterchip und reduziert die Anzahl der Steuerleitungen. Insbesondere wird die Anzahl der Ausgabeleitungen an eine externe Testeinrichtung auf 1 gesenkt. Ferner ist der erfindungsgemäße Adressgenerator durch die optionell vorgeschlagenen Erweiterungen in optimaler Weise an unterschiedliche funktionelle Anforderungen anpassbar.

Nachstehend wird ein derzeit bevorzugtes Ausführungsbeispiel des Adressgenerators bezogen auf die Zeichnung näher beschrieben.

Die Figuren zeigen im einzelnen:
Fig. 1 den Schaltungsblock "Adressgenerator" für M Bit mit den erfindungsgemäß erforderlichen und den für eine erweiterte Funktionalität vorgesehenen weiteren Ein-Ausgabe-, Programmier- und Steuerleitungen;
Fig. 2 ein funktionell aufgelöstes Blockschaltbild einer Speicher/Registerstufe (1 Bit) des in Fig. 1 dargestellten Adressgenerators, und
Fig. 3 eine MOS-Transitoren aufweisende Schaltung, die eine bevorzugte Implementierung einer Speicher- oder Registerstufe des Adressgenerators der Erfindung veranschaulicht;
Fig. 4 ein Signal-Zeitdiagramm für den Testbetrieb der MOS-Latchschaltung gem. Fig. 3 und
Fig. 5 Signalzustände am Ausgang der Speicherstufe.

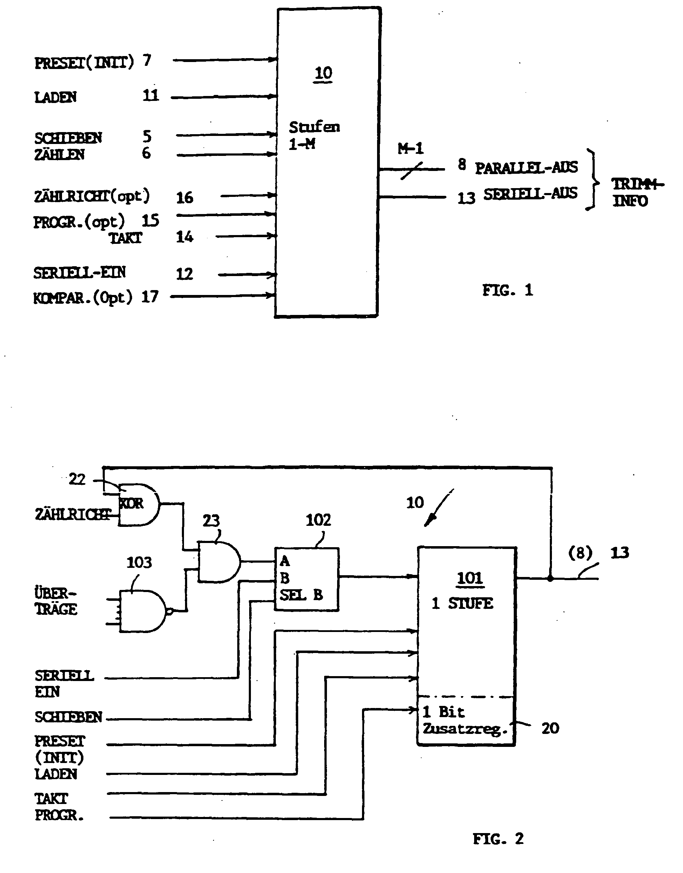

Fig. 1 zeigt einen Schaltungsblock eines bevorzugten Ausführungsbeispiels eines erfindungsgemäßen Adressgenerators, der allgemein mit der Bezugszahl 10 bezeichnet ist.

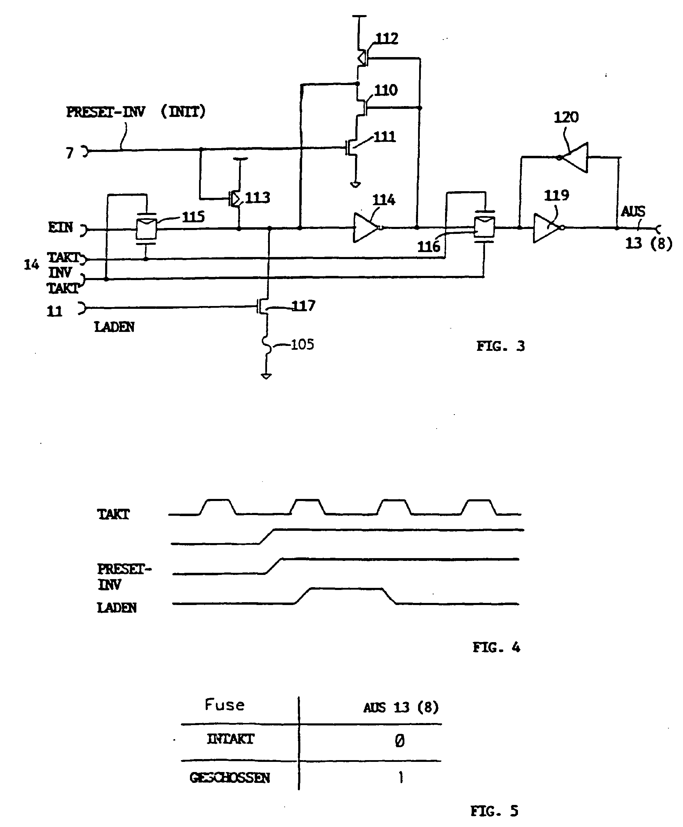

Der Adressgenerator 10 in Fig. 1 ist für M Bit ausgelegt und enthält somit M Speicher- oder Registerstufen, die jeweils aus einem MOS-Speicherlatch (s. Fig. 3)bestehen.

Auf ein einem "Preset"-Eingang 7 zugeführtes Initialisiersignal wird die einem parallelen Eingang 11 zugeführte parallele Lade- oder Fuseinformation bei Gegenwart eines an einem Takteingang 14 anliegenden Taktsignals "Takt" in die Speicherlatches des Adressgenerators 10 übernommen.

Mit einem an einem Eingang 6 anliegenden Zählsignal "Zählen" wird der Adressgenerators 10 nach Art eines Zählers betrieben und zählt bei jedem Taktsignal am Takteingang 14 in Übereinstimmung mit einem Zählrichtungssignal 16 vorwärts oder rückwärts. Mit einem an einem Eingang 5 anliegenden Signal "Schieben" ist der Adressgenerator 10 als Schieberegister betreibbar.

Zu der obigen Beschreibung ist zu erwähnen, dass der Adressgenerator elektrische Fuses enthält und die am Ladeeingang 11 parallel anliegende Fuseinformation die einzelnen Bits des Adressgenerators 10 nur bei jeweils intakten (oder alternativ nur bei jeweils geschossenen) Fuses in den komplementären Zustand zum Initialisierungswert bringt.

Die elektrischen Fuses können Polysiliziumbrücken, Gateoxidbrücken, Wolfram-, Aluminium-, oder andere Metallbrücken sein.

Die durch den Adressgenerator 10 generierte Adresse liegt einem Parallelausgang 8 an, der mit der erwähnten Trimmschaltung verbunden oder verbindbar ist.

Weiterhin weist der Adressgenerator 10 zum Test optionell einen seriellen Eingang 12 und einen seriellen Ausgang 13 auf, mit dem der Zählerstand bzw. die Fuseinformation des Adressgenerators seriell auslesbar ist. Dies kann nicht zerstörend durch Rückkopplung des seriellen Ausgangs 13 auf den seriellen Eingang 12 durch in Fig. 1 nicht dargestellte Rückkopplungsglieder oder zerstörend geschehen, indem andere (Test-) Information auf den seriellen Eingang gegeben wird.

Der Adressgenerator 10 ist außerdem durch einen Programmiereingang 15 erweiterbar, der die in den Speicherlatches des Adressgenerators 10 vorhandene Information bitweise zur Programmierung der entsprechenden Fuses verwendet.

Weiterhin kann der Adressgenerator 10 um ein zusätzliches Speicherlatch 20 erweitert werden, in welches das an einem Eingang 17 anliegende Signal eines (nicht gezeigten) Spannungskomparators (vgl. DE 199 16 244.1) übernommen werden und seriell mit dem Adressenwert ausgegeben werden kann.

Fig. 2 zeigt in Form eines Blockschaltbilds eine Speicherstufe 101 des in Fig. 1 dargestellten Adressgenerators 10. Hier fallen der serielle und der parallele Ausgang zusammen.

Die bei dem Zählvorgang des Adressgenerators 10 auftretenden Überträge liegen über ein logisches NAND-Glied 103 der Speicherstufe 101 des Adressgenerators 10 an.

Rückkopplungsglieder 22, 23 dienen dazu, die am Ausgang 13 anliegende Information zum seriellen Eingang zurückzukoppeln. Die vom (seriellen) Ausgang 13 über die Rückkopplungsglieder 22 und 23 zurückgekoppelte Information, die mit dem NAND-Glied 103 kombinierten Überträge und der serielle Eingang 12 werden durch einen Multiplexer 102 gemultiplext.

In Fig. 3 ist eine derzeit bevorzugte Implementierung einer Speicherlatchstufe 101 gemäß Fig. 2 dargestellt.

Die Speicherlatchstufe 101 weist MOS-Transistoren 110, 111, 112 und 113 sowie ein Invertierglied 114 auf. Die Eingangsinformation "IN", die am Ausgang des Multiplexers 102 gemäß Fig. 2 anliegt, wird über ein Transfergate 115 eingegeben, das von dem am Takteingang 14 anliegenden Taktsignal "CLK, CLK-INV" durchgeschaltet bzw. gesperrt wird. Gleichermaßen wird die vom Speicherlatch 101 gebildete Ausgangsinformation von einem weiteren Transfergate 116, das ebenfalls vom Taktsignal "CLK, CLK-INV" durchgeschaltet bzw. gesperrt wird, dem Ausgang über zwei Invertierglieder 120, 121 zugeführt. Der Ladeeingang 11 ist über einen MOS-Transistor 117 einer elektrischen Fuse 105 angelegbar.

In Fig. 4 ist ein Signal-Zeitdiagramm für den Testbetrieb der in Fig. 3 gezeigten MOS-Latchschaltung dargestellt, während Fig. 5 eine Wahrheitstabelle der Signalzustände der in Fig. 3 gezeigten MOS-Latchschaltung abhängig davon darstellt ob die elektrische Fuse 105 geschossen ist oder nicht.

## Patentansprüche

1. Adressgenerator zur Erzeugung von Adressen für eine On-Chip-Trimmschaltung zur Abstimmung einer auf einem Halbleiterchip erzeugten Referenzspannung, wobei der Adressgenerator (10) elektrische Fuses (105) aufweist,
**dadurch gekennzeichnet, dass**
der Adressgenerator (10) eine bestimmte Anzahl M von aus jeweils einem Speicherlatch bestehenden Stufen (1, 2, 3, ..., M) aufweist, die auf ein einem Steuereingang (5, 6) des Adressgenerators (10) zugeführtes Steuersignal und auf ein einem Takteingang (14) desselben angelegtes Taktsignal wahlweise als synchroner Zähler oder als Schieberegister betreibbar sind, wobei M gleich oder größer als 1 ist und dass in den elektrischen Fuses (105) eine vom Adressgenerator (10) generierte Adresse für die Trimmschaltung bei Übereinstimmung einer veränderlichen Referenzspannung des Halbleiterchips mit einer von außen zugeführten Vergleichsspannung dauerhaft speicherbar ist.

2. Adressgenerator nach Anspruch 1,
**dadurch gekennzeichnet, dass**
die Speicherlatches des Adressgenerators MOS-Transistoren in einer zur Anpassung des Pegels der den elektrischen Fuses (105) zuzuführenden Adressinformation an den CMOS-Pegel eingerichteten Anordnung aufweisen.

3. Adressgenerator nach Anspruch 1 oder 2,
**dadurch gekennzeichnet, dass**
die Speicherlatches einen gemeinsamen Initialisierungseingang (7) und einen Ladeeingang (11) so aufweisen, dass ein am Ladeeingang angelegtes Signal nur bei jeweils intakter (oder geschossener) Fuse (105) die jeweilige Latchinformation des Speicherlatches in den zum Initialisierungswert komplementären Wert bringt.

4. Adressgenerator nach einem der vorangehenden Ansprüche,
**dadurch gekennzeichnet, dass**
er weiterhin einen seriellen Eingang (12) und einen seriellen Ausgang (13) aufweist, um den Zählerstand bzw. die Fuseinformation seriell auszulesen.

5. Adressgenerator nach Anspruch 4,
**dadurch gekennzeichnet, dass**
er weiterhin Rückkopplungsglieder (22,23) aufweist, die den seriellen Ausgang (13) wahlweise zum seriellen Eingang (12) zurückkoppeln.

6. Adressgenerator nach einem der vorangehenden Ansprüche,
**dadurch gekennzeichnet, dass**
er weiterhin einen Programmiereingang (15) aufweist, um mit der in den Speicherlatches vorhandenen Information bitweise die jeweiligen Fuses zu programmieren.

7. Adressgenerator nach einem der vorangehenden Ansprüche,
**dadurch gekennzeichnet, dass** weiterhin ein Zählrichtungswähleingang (16) vorgesehen ist.

8. Adressgenerator nach einem der vorangehenden Ansprüche,
**dadurch gekennzeichnet, dass**
er weiterhin ein zusätzliches Speicherlatch (20) aufweist, in welches ein momentanes (JA/NEIN) Vergleichsergebnis eines Spannungskomparators, der die momentan von der Trimmschaltung erzeugte Spannung mit der externen Vergleichsspannung vergleicht, speicherbar und zusammen mit den generierten Adresswerten am seriellen Ausgang ausgebbar ist.

## Claims

1. Address generator for generating addresses for an on-chip trimming circuit for trimming a reference voltage generated on a semiconductor chip, the address generator (10) having electrical fuses (105),
**characterized in that**
the address generator (10) has a specific number M of stages (1, 2, 3,...,M) which in each case comprise a storage latch and which can optionally be operated as synchronous counter or as shift register in response to a control signal fed to a control input (5, 6) of the address generator (10) and in response to a clock signal applied to a clock input (14) of said address generator, where M is greater than or equal to 1, and **in that** in the electrical fuses (105) it is possible to permanently store an address generated by the address generator (10) for the trimming circuit in the event of a variable reference voltage of the semiconductor chip corresponding to a comparison voltage fed in externally.

2. Address generator according to Claim 1,
**characterized in that**
the storage latches of the address generator have MOS transistors in an arrangement set up for adapting the level of the address information to be fed to the electrical fuses (105) to the CMOS level.

3. Address generator according to Claim 1 or 2,
**characterized in that**
the storage latches have a common initialization input (7) and a loading input (11) such that a signal applied to the loading input brings the respective latch information of the storage latch to the value complementary to the initialization value only in the event of in each case an intact (or closed) fuse (105).

4. Address generator according to one of the preceding claims,
**characterized in that**
it furthermore has a serial input (12) and a serial output (13) in order to read out the counter reading or the fuse information serially.

5. Address generator according to Claim 4,
**characterized in that**
it furthermore has feedback elements (22, 23) which optionally feed back the serial output (13) to the serial input (12).

6. Address generator according to one of the preceding claims,
**characterized in that**
it furthermore has a programming input (15) in order to program the respective fuses bit by bit with the information present in the storage latches.

7. Address generator according to one of the preceding claims,
**characterized in that**
a counting direction selection input (16) is furthermore provided.

8. Address generator according to one of the preceding claims,
**characterized in that**
it furthermore has an additional storage latch (20), in which an instantaneous (YES/NO) comparison result of a voltage comparator, which compares the voltage instantaneously generated by the trimming circuit with the external comparison voltage, can be stored and can be output together with the generated address values at the serial output.

## Revendications

1. Générateur d'adresses pour la production d'adresses pour un circuit d'ajustement sur puce, pour l'accord d'une tension de référence produite sur une puce à semi-conducteur, le générateur (10) d'adresses ayant des fusibles (105) électriques,
**caractérisé en ce que** le générateur (10) d'adresses a un nombre M déterminé d'étages (1, 2, 3, ...M) qui sont constitués respectivement d'un verrou de mémoire, qui peuvent fonctionner au choix comme compteur synchrone ou comme registre à décalage sur un signal de commande envoyé à une entrée (5, 6) de commande du générateur (10) d'adresses et sur un signal d'horloge appliqué sur une entrée (14) d'horloge de celui-ci, M étant supérieur ou égal à 1 et **en ce qu'**il peut être mémorisé de manière permanente dans les fusibles (105) électriques une adresse générée par le générateur (10) d'adresses pour le circuit d'ajustement lorsqu'une tension de référence variable de la puce à semi-conducteur coïncide avec une tension de comparaison appliquée de l'extérieur.

2. Générateur d'adresses suivant la revendication 1,
**caractérisé en ce que** les verrous de mémoire du générateur d'adresses ont des transistors MOS suivant un agencement au niveau CMOS, destiné à adapter le niveau de l'information d'adresse à envoyer aux fusibles (105) électriques.

3. Générateur d'adresses suivant la revendication 1 ou 2,
**caractérisé en ce que** les verrous de mémoire ont une entrée (7) commune d'initialisation et une entrée (11) de charge, de façon à ce qu'un signal appliqué à l'entrée de charge ne porte l'information respective du verrou de mémoire dans la valeur complémentaire de la valeur d'initialisation que si le fusible (105) est respectivement intact (a sauté).

4. Générateur d'adresses suivant l'une des revendications précédentes, **caractérisé en ce qu'**il a en outre une entrée (12) en séquence et une sortie (13) en séquence, pour lire en séquence l'état du compteur ou l'information de fusible.

5. Générateur d'adresses suivant la revendication 4,
**caractérisé en ce qu'**il a en outre des éléments (22, 23) de réaction, qui couplent en retour la sortie (13) en séquence au choix avec l'entrée (12) en séquence.

6. Générateur d'adresses suivant l'une des revendications précédentes,
**caractérisé en ce qu'**il a en outre une entrée (15) de programmation, pour programmer bit par bit les fusibles respectifs par l'information présente dans les verrous de mémoire.

7. Générateur d'adresses suivant l'une des revendications précédentes,
**caractérisé en ce qu'**il est prévu en outre une entrée (16) de sélection du sens de comptage.

8. Générateur d'adresses suivant l'une des revendications précédentes,
**caractérisé en ce qu'**il a en outre un verrou (20) supplémentaire de mémoire, dans lequel peut être mémorisé et émis, ensemble avec les valeurs d'adresse générées sur la sortie en séquence, un résultat de comparaison instantanée (oui/non) d'un comparateur de tension, qui compare la tension produite instantanément par le circuit d'ajustement à la tension de comparaison extérieure.
